# EUROPEAN PATENT APPLICATION

(11) **EP 4 351 289 A1**
(43) Date of publication of application: **10.04.2024**
(21) Application number: 23197417.1
(22) Date of filing: 14.09.2023
(51) Int. Cl.: H05K 5/00

(54) **HOUSING FOR USING IN SPACE ENVIRONMENT**

(30) Priority: 29.09.2022 KR 20220123923
(71) Applicant: Korea Aerospace Research Institute, Daejeon 34133 (KR)
(72) Inventor: JUNG, Jin Pyong, Dunsan-ro (KR); JEONG, Shin Jeong, Cheongsa-ro (KR)
(74) Representative: dompatent von Kreisler Selting Werner - Partnerschaft von Patent- und Rechtsanwälten mbB

(57) **Abstract**

The present invention relates to a housing that may apply industrial electronic components even in a space environment, and more particularly, to a universal mounting housing mounted on space equipment used in a space environment and housing a plurality of electronic components. The universal mounting housing may include a composite wall that constitutes an outer appearance of the housing to form a sealed inner space, a heat emitter that is formed inside or outside the composite wall to emit internal heat, and a connector pad that is formed on one side of the housing and is formed so that the electromagnetic wave filter communicates an inner space with an outside.

## Description

### CROSS-REFERENCE TO RELATED APPLICATIONS

This application claims priority under 35 U.S.C. §119 to Korean Patent Application No. 10-2022-0123923, filed on 9 29, 2022, in the Korean Intellectual Property Office, the disclosure of which is incorporated herein by reference in its entirety.

### TECHNICAL FIELD

The following disclosure relates to a housing, and more particularly, to a universal mounting housing capable of protecting electronic components in a space environment.

### BACKGROUND

In general, the space environment is manufactured to be robust and highly reliable compared to electronic parts used for the same purpose on the ground due to harsh environments such as rapid temperature change, shock, vibration, radiation, and electromagnetic waves.

However, in order to develop and manufacture a system that satisfies the space environment, there are problems in that complex auxiliary devices, long development and verification periods, high costs are required, and the burden on the size, weight, and power of the device increases.

In addition, there is a problem in that the risk level increases when a problem occurs in the function of an electronic component for some reason because multiplexing of electronic components is difficult due to cost limitations.

### [Related Art Document]

### [Patent Document]

Korean Utility Model Laid-Open Publication No. 20-1997-0003705 ("Hard disk device having electromagnetic shielding device", Filing Date March 4, 1997)

### SUMMARY

An embodiment of the present invention is directed to providing a housing having an electromagnetic environment capable of protecting from temperature, shock, vibration, and radiation so that relatively low-cost industrial electronic components commonly used on the ground may be used even in a space environment.

In addition, an embodiment of the present invention is directed to providing a housing capable of minimizing power consumption and cost by replacing electronic components for space with industrial electronic components.

In addition, an embodiment of the present invention is directed to providing a housing capable of coping with electromagnetic waves that may vary depending on an environment.

In addition, an embodiment of the present invention is directed to providing a housing that requires only a minimal verification procedure even if a built-in system is changed.

In one general aspect, a universal mounting housing in which a plurality of electronic components are housed includes: a composite wall that constitutes an outer appearance of the housing to form a sealed inner space; a heat emitter that is formed inside or outside the composite wall to emit internal heat; and a connector pad that is formed on one side of the housing and is formed so that an electromagnetic wave filter makes the inner space communicate with an outside.

The composite wall may include at least one a mesh-type electromagnetic wave shielding layer that shields an electromagnetic wave, a solar heat shielding layer that shields solar heat, a heat transfer layer that includes a heat transfer medium or a heat wire, radiation shielding layers that overlap on both sides in a form surrounding the electromagnetic wave shielding layer, the solar heat shielding layer, and the heat transfer layer, and shield radioactivity, and metal layers that are formed on outermost sides of both sides of the composite wall.

A material of the electromagnetic wave shielding layer may contain copper, and a material of the radiation shielding layer may contain aluminum.

The heat emitter may include a heat pipe that receives heat from the heat transfer layer, and converts the heat to the outside in a form of an electromagnetic wave and emits the heat.

The housing may include a controller and a temperature sensor detecting an internal temperature therein, and the controller may monitor a temperature of the temperature sensor and the plurality of electronic components and adjust the temperature through the heat emitter and the heat transfer layer.

The housing may further include a damper that dissipates shock and vibration in a mounting part coupled to space equipment.

The connector pad may be attachable and detachable together with the electromagnetic wave filter.

The housing may further include a center of gravity control means that detects a total weight and adjusts a center of gravity.

The center of gravity control means may be formed at corners of the housing, respectively.

### BRIEF DESCRIPTION OF THE DRAWINGS

FIG. 1 is a perspective view of a universal mounting housing according to an embodiment of the present invention.
FIG. 2 is a cross-sectional view of a composite wall of the universal mounting housing according to one embodiment of the present invention.
FIG. 3 is a side view of a universal mounting housing according to another embodiment of the present invention.
FIG. 4 is a cross-sectional view of the universal mounting housing according to another embodiment of the present invention.

### [Detailed Description of Main Elements]

1: Transceiver
2: Modulator
10: Universal mounting housing
100: Composite wall
110: Connector pad
111: Electromagnetic wave filter
200: Heat emitter
210: heat wire, heat pipe
300: Controller
310: Heat wire, heat pipe
320: Temperature sensor
400: Damper
500: Center of gravity control means

### DETAILED DESCRIPTION OF EMBODIMENTS

Hereinafter, the technical spirit of the present invention will be described in more detail with reference to the accompanying drawings. Terms and words used in the present specification and claims are not to be construed as a general or dictionary meaning, but are to be construed as meaning and concepts meeting the technical ideas of the present invention based on a principle that the present inventors may appropriately define the concepts of terms in order to describe their inventions in best mode. Therefore, configurations described in exemplary embodiments and the accompanying drawings of the present invention do not represent all of the technical spirits of the present invention, but are merely most preferable embodiments. Therefore, the present invention should be construed as including all the changes, and substitutions included in the spirit and scope of the present invention at the time of filing this application.

**[Table 1]**

| | Industrial Use | Space Use |
|---|---|---|
| Temperat ure | -40° to 85° | -190° to 150° |
| Shock/Vi bration | General commercial standard (max. hundreds G) | MIL-STD-810 space grade (max. thousands G) |
| Radiatio n | 5 to 10krad | max. 10,000krad |
| Electrom agnetic Environm ent | General commercial standard | MIL-STD-461 space grade |

Table 1 compares the required specifications of industrial electronic components and electronic components for space. The electronic components for space should be manufactured to be robust and highly reliable compared to the industrial electronic components used for the same purpose on the ground due to harsh environmental factors such as rapid temperature change, shock, vibration, radiation, and electromagnetic waves. That is, compared to the industrial electronic components, the electronic components for space are expensive to manufacture, and inevitably have a larger volume and weight, and as a result, there are many restrictions in configuring space equipment.

In order to solve these problems, the present invention discloses a universal mounting housing capable of protecting industrial electronic components to be used even in a space environment.

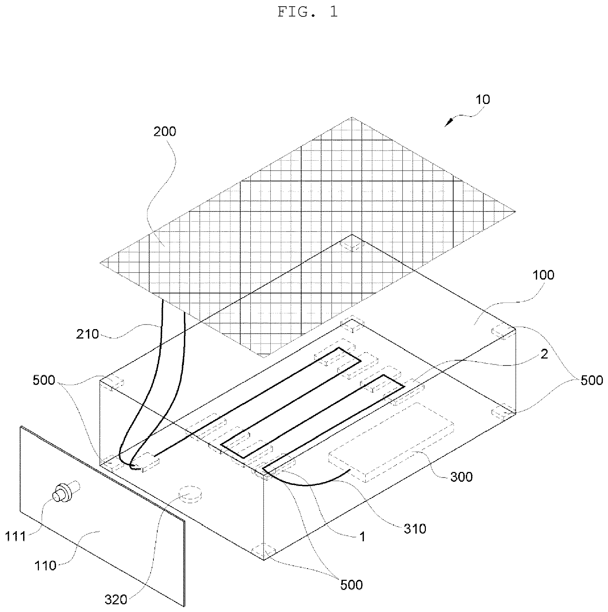

FIG. 1 is a diagram illustrating the whole of a universal mounting housing 10 according to an embodiment of the present invention. The universal mounting housing 10 according to the present invention is designed so that the industrial electronic components commonly used on the ground may be used even in a space environment, and is mounted on space equipment used in a space environment and houses a plurality of electronic components. The universal mounting housing 10 may largely include a composite wall 100, a heat emitter 200, and a connector pad 110 forming an electromagnetic wave filter 11.

In more detail, as illustrated, the universal mounting housing 10 according to the present invention includes the composite wall 100 that constitutes an outer appearance of the universal mounting housing 10 to form a sealed inner space, the heat emitter 200 that is formed inside or outside the composite wall 100 to emit internal heat, and the connector pad 110 that is formed on one side of the universal mounting housing 10 and formed so that the electromagnetic wave filter 11 makes an inner space communicate with the outside.

In this case, the composite wall 100 is formed by stacking a plurality of different material layers. Each material layer may be composed of elements for preventing functional degradation of electronic components in a space environment, such as temperature control, shock/vibration prevention, radiation shielding, and electromagnetic wave shielding.

In addition, the heat emitter 200 is connected to the composite wall 100 and a heat wire or the like provided therein to emit internal heat to the outside, and may communicate with the inside of the universal mounting housing 10 through heat pipes 210 and 310 and may be formed outside. In this case, as illustrated, the heat emitter 200 may be formed of a grid-like mesh to maximize a surface area exposed to the outside and minimize weight. In addition, the heat emitter 200 may convert internal heat into electromagnetic waves and emit the heat to the outside in consideration of a space environment without a heat transfer medium such as air.

In this case, the universal mounting housing 10 may further include a controller 300 and a temperature sensor 320 together with electronic components therein. The controller 300 may continuously monitor temperature and functional status by being linked with internal electronic components such as a transceiver and a modulator, and may control temperature or generate status information. The temperature sensor 320 may detect a temperature of the inner space of the universal mounting housing 10 and transmit temperature information to the controller 300.

In addition, the universal mounting housing 10 may include a center of gravity control means 500. The center of gravity control means 500 may detect the total weight of the universal mounting housing 10 and adjust the center of gravity. For example, as illustrated, the center of gravity control means 500 may be formed at corners of the universal mounting housing 10, respectively. The center of gravity control means 500 may detect the side on which the weight is concentrated when the setting of the internal system is completed and generate an adjustment signal for readjusting the center of gravity, or may further include operating means to directly readjust the center of gravity. The present invention may include an embodiment in which the center of gravity control means 500 is disposed only at the upper or lower corner of the universal mounting housing 10, or disposed at both the upper and lower corners.

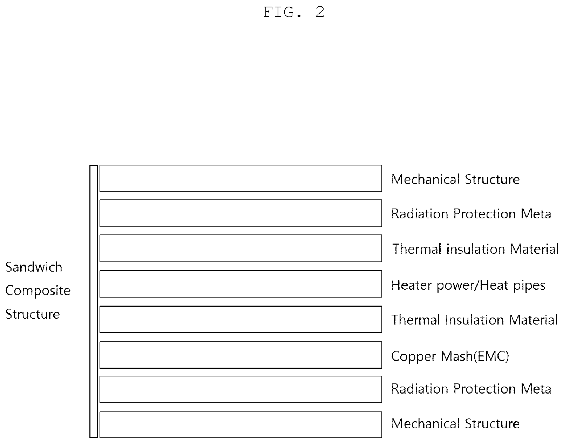

FIG. 2 is an enlarged cross-sectional view of a portion of the universal mounting housing 10 according to the present invention, and illustrates each layer of the composite wall 100. The composite wall 100 may include an electromagnetic wave shielding layer, a solar heat shielding layer, a heat transfer layer, the electromagnetic wave shielding layer, a radiation shielding layer, and a metal layer.

More specifically, the electromagnetic wave shielding layer is to prevent interference between electronic components that are radiated from celestial bodies in space or other equipment and perform a role such as internal transmission and reception, and may be configured in the form of a mesh for shielding electromagnetic waves, and may be made of copper as its material.

In addition, the solar heat shielding layer may be manufactured by including a thermal insulating material in order to minimize a temperature deviation that increases due to sunlight.

In addition, the heat transfer layer may be manufactured, including a heat pipe or a heat wire wired to surround internal electronic components of the universal mounting housing 10. In this case, the heat transfer layer may be controlled by the controller 300, and the controller 300 may continuously adjust the internal temperature through the heat transfer layer by being linked with internal electronic components such as the temperature sensor 320, the transceiver 1, and the modulator 2.

In addition, the radiation shielding layer is for shielding radioactivity that causes damage or malfunction to electronic components, and may be made of aluminum as its material. The radiation shielding layer may be formed in the form of a sandwich in which it overlaps in a form surrounding the electromagnetic wave shielding layer, the solar heat shielding layer, and the heat transfer layer. That is, it is preferable that the radiation shielding layer is formed on both sides in a form surrounding the top and bottom of the electromagnetic wave shielding layer, the solar heat shielding layer, and the heat transfer layer in a stacking direction.

In addition, the metal layer is formed by stacking on the outermost sides of the composite wall 100, respectively. The metal layer may be stacked for the purpose of protecting the universal mounting housing 10 from external physical force, reflecting sunlight, and protecting other layers constituting the composite wall 100.

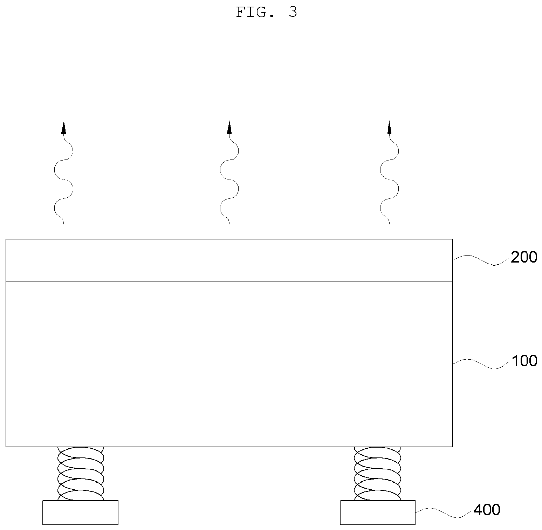

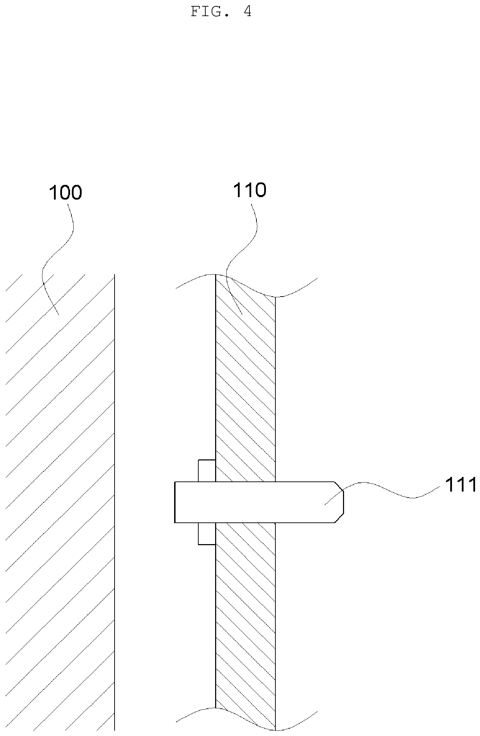

FIGS. 3 and 4 each illustrate another embodiment of the universal mounting housing 10 according to the present invention.

Referring to FIG. 3, the universal mounting housing 10 may further include a damper 400 for dissipating vibration and shock force. The damper 400 is preferably formed in a mounting portion coupled to the universal mounting housing 10 and space equipment to be mounted.

In this case, the damper 400 may be linked with a center of gravity control means 500 illustrated in FIG. 1. That is, when the center of gravity control means 500 generates a signal for adjusting the center of gravity, the damper 400 may implement an operation of adjusting the center of gravity.

In addition, as illustrated, the universal mounting housing 10 forms the heat emitter outside, but may be installed as far away as possible from the mounting part. This is to minimize the effect of electromagnetic waves emitted after being converted from internal heat on space equipment, and its location may be adjusted in some cases.

Referring to FIG. 4, the universal mounting housing 10 may further include the connector pad 110 including the electromagnetic wave filter 11 on one side. The connector pad 110 is attachable to and detachable from the universal mounting housing 10 together with the electromagnetic wave filter 11. This is a configuration for flexibly replacing the electromagnetic wave filter 11 that removes noise except for the electromagnetic waves of a necessary specific section, and has the advantage of being able to easily apply the electromagnetic wave filter 11 of different specifications according to the required specifications. That is, the electromagnetic wave filtering section may be set in such a way that the connector pad 110 manufactured integrally with the electromagnetic filter 11 is provided according to the required specifications and the entire connector pad 110 is replaced according to the purpose.

According to the present invention, a universal mounting housing can protect industrial electronic components from temperature, shock, vibration, and radiation to be used in a space environment, thereby minimizing manufacturing costs for space equipment and miniaturizing the space equipment.

In addition, according to the universal mounting housing of the present invention, it is possible to cope with functional degradation or damage of specific components by installing a plurality of electronic components.

In addition, according to the universal mounting housing of the present invention, it is possible to control temperature in real time even in a space environment with a large temperature difference.

In addition, according to the universal mounting housing of the present invention, it is possible to easily set an electromagnetic wave filtering range by easily replacing an electromagnetic wave filter.

In addition, the universal mounting housing according to the present invention can be applied to the space environment after undergoing minimal verification because the overall weight and center of gravity may be readjusted even if a built-in system is changed.

## Claims

1. A universal mounting housing in which a plurality of electronic components are housed, the housing comprising:
a composite wall that constitutes an outer appearance of the housing to form a sealed inner space;
a heat emitter that is formed inside or outside the composite wall to emit internal heat; and
a connector pad that is formed on one side of the housing and is formed so that an electromagnetic wave filter makes the inner space communicate with an outside.

2. The housing of claim 1, wherein the composite wall includes at least one a mesh-type electromagnetic wave shielding layer that shields an electromagnetic wave,
a solar heat shielding layer that shields solar heat,
a heat transfer layer that includes a heat transfer medium or a heat wire,
radiation shielding layers that overlap on both sides in a form surrounding the electromagnetic wave shielding layer, the solar heat shielding layer, and the heat transfer layer, and shield radioactivity, and
metal layers that are formed on outermost sides of both sides of the composite wall.

3. The housing of claim 2, wherein a material of the electromagnetic wave shielding layer contains copper, and
a material of the radiation shielding layer contains aluminum.

4. The housing of claim 2, wherein the heat emitter includes a heat pipe that receives heat from the heat transfer layer, and converts the heat to the outside in a form of an electromagnetic wave and emits the heat.

5. The housing of claim 4, wherein the housing includes a controller and a temperature sensor detecting an internal temperature therein, and
the controller monitors a temperature of the temperature sensor and the plurality of electronic components and adjusts the temperature through the heat emitter and the heat transfer layer.

6. The housing of claim 1, wherein the housing further includes a damper that dissipates shock and vibration in a mounting part coupled to space equipment.

7. The housing of claim 1, wherein the connector pad is attachable and detachable together with the electromagnetic wave filter.

8. The housing of claim 1, wherein the housing further includes a center of gravity control means that detects a total weight and adjusts a center of gravity.

9. The housing of claim 8, wherein the center of gravity control means is formed at corners of the housing, respectively.
